# EUROPÄISCHE PATENTSCHRIFT

(11) **EP 1 898 466 B1**
(45) Veröffentlichungstag und Bekanntmachung des Hinweises auf die Patenterteilung: **23.08.2017**
(21) Anmeldenummer: 07011533.2
(22) Anmeldetag: 13.06.2007
(51) Int. Cl.: H01L 23/00, H01R 4/30, H01L 23/04, H01L 23/48, H01L 25/07, H01R 4/48, H01R 12/61, H05K 1/18, H05K 3/32, H05K 3/36, H01R 12/63

(54) **Gehauste Halbleiterschaltungsanordnung mit Kontakteinrichtung**
Encased PCB switch assembly with contact device
Circuit semi-conducteur dans un boîtier doté d'un dispositif de contact

(30) Priorität: 14.06.2006 DE 102006027482
(43) Veröffentlichungstag der Anmeldung: 12.03.2008
(73) Patentinhaber: Semikron Elektronik GmbH & Co. KG Patentabteilung, 90431 Nürnberg (DE)
(72) Erfinder: Göbl, Christian, 90441 Nürnberg (DE); Kobolla, Harald, Dr., 90556 Seukendorf (DE)

(56) Entgegenhaltungen:
- DE-A1- 10 355 925
- DE-A1-102004 025 609
- DE-A1-102006 013 078
- DE-C1- 3 915 611
- GB-A- 578 576

## Beschreibung

Die Erfindung beschreibt eine gehauste Halbleiterschaltungsanordnung, beispielhaft ein Leistungshalbleitermodul, mit Kontakteinrichtungen zur elektrischen Verbindung der Halbleiterbauelemente mit externen Zuleitungen.

Hierbei soll im Folgenden mit dem Begriff des externen Lastanschlusses eine Verbindung zwischen einem inneren Verbindungselement des Leistungshalbleitermoduls mit einer externen Zuleitung verstanden werden, wobei die Verbindungseinrichtung mit den Leistungskontakteinrichtungen eines Leistungshalbleiterbauelements verbunden ist.

Analog wird mit dem Begriff externer Steueranschluss im Folgenden eine Verbindung zwischen einem inneren Verbindungselement des Leistungshalbleitermoduls mit einer externen Zuleitung verstanden werden, wobei die Verbindungseinrichtung mit den Steuerkontakteinrichtungen eines Leistungshalbleiterbauelements verbunden ist. Ebenso sollten unter diesen Begriff auch alle weiteren externen Anschlüsse beispielhaft von integrierten Schaltungen, subsumiert werden, die keine externen Lastanschlüsse sind. Auch wenn die erfindungsgemäße Halbleiterschaltungsanordnung an Hand einer Ausführung als Leistungshalbleitermodul dargestellt wird bedeutet dies keine Beschränkung der Allgemeinheit.

Einen Ausgangspunkt der Erfindung bilden Leistungshalbleitermodule, wie sie beispielhaft aus der DE 10 2004 0255 609 A1, oder der DE 103 55 925 A1 bekannt sind. Erstgenannte Druckschrift offenbart ein Leistungshalbleitermodul in Schraub-Druckkontaktierung. Die externen Lastanschlüsse des Leistungshalbleitermoduls mit einer externen Leiterplatte werden hierbei mittels eine Schraubverbindung nach dem Stand der Technik erreicht. Die externen Steueranschlüsse sind hierbei ausgebildet als Verbindung zwischen einem Federkontaktelement und einem Leiterbahnabschnitt der externen Leiterplatte. Erfindungsgemäß erfolgt zur elektrischen Kontaktierung eine Druckeinleitung auf die Steueranschlüsse durch die Anordnung und Verschraubung der Leiterplatte mit den Lastanschlusselementen. Die Ausgestaltung eines Leistungshalbleitermoduls in der genannten Art ist besonders geeignet für Strombelastungen der Lastanschlüsse von mehr als 10 Ampere.

Die DE 103 55 925 A1 offenbart eine Verbindungseinrichtung für Leistungshalbleiterbauelemente bestehend aus einem Folienverbund einer ersten und einer zweiten leitenden Folie mit einer isolierenden Zwischenlage. Die Leistungshalbleiterbauelemente sind mit der ersten leitenden Schicht mittels Ultraschallschweißen dauerhaft sicher elektrisch verbunden. Die modulinterne schaltungsgerechte Verbindung der Leistungshalbleiterbauelemente, die sowohl interne Last- als auch Steueranschlüsse beinhaltet ist hier offen gelegt. Allerdings offenbart die genannte Druckschrift keine Details der externen Last- und Steueranschlüsse.

Die nicht vorveröffentlichte DE 10 2006 013 078 offenbart ein Leistungshalbleitermodul mit einem Gehäuse, einem Substrat mit Leiterbahnen und auf diesen Leiterbahnen schaltungsgerecht angeordnete Leistungshalbleiterbauelemente. Weiterhin weist das Leistungshalbleitermodul eine Verbindungseinrichtung auf, wobei diese jeweils aus einem Folienverbund aus einer ersten und einer zweiten leitenden Schicht mit einer zwischen diesen leitenden Schichten angeordneten isolierenden Schicht besteht.

Die GB 578 576 A offenbart einen elektrischen Kontaktstecker für eine Vielzahl von koaxial ausgebildeten Kontaktanschlüssen. Weiterhin offenbart die Anmeldung einen Kontaktstift, das ein erstes Kontaktteil aufweist, und ein passendes Aufnahmeteil, das ein zweites Kontaktteil aufweist. Die Verbindung des Aufnahmeteils und des elektrischen Kontaktsteckers wird durch eine mit Schrauben befestigte reversible Federkontaktierung hergestellt.

Die DE 39 15 611 C1 offenbart eine elektrische Steckverbindung, die ein Aufnahmeteil in dem ein Steckerschlitz mit einer Einführöffnung ausgebildet ist und ausfedernde Kontaktfedern. Weiter weist die Erfindung ein Steckerteil auf, mit einem elektrisch leitenden Kontaktteil, das in den Steckerschlitz des Isoliergehäuses einführbar ist, auf. Das elektrische Kontaktteil bildet eine elektrisch leitende Verbindung über die gefederten Kontaktnasen mit dem Kontaktteil des Aufnahmeteils.

Die jeweiligen leitenden Schichten sind in sich strukturiert und bilden somit dort Leiterbahnen aus. Die erste leitende Schicht des Folienverbunds weist erste, als Punktschweißverbindungen ausgebildete interne Lastanschlüsse zu Leistungsanschlussflächen von Leistungshalbleiterbauelementen auf. Ebenso weist diese erste leitende Schicht auf einer weiteren Leiterbahn interne Steueranschlüsse zu Steueranschlussflächen von Leistungshalbleiterbauelementen auf. Weiterhin weist die erste leitende Schicht externe Lastanschlüsse zur Lastverbindung mit einer Leiterplatte auf. Die zweite leitende Schicht weist gleichartige externe Steueranschlüsse zur Steuerverbindung mit der Leiterplatte auf, wobei diese Anschlüsse jeweils als Lötverbindungen ausgebildet sind.

Der Folienverbund selbst weist Folienabschnitte zwischen den internen, sowie den externen Anschlüssen auf, die in Führungsabschnitten des Gehäuses angeordnet sind, wobei die externen Anschlüsse parallele Flächennormalen aufweisen.

Der Erfindung liegt die Aufgabe zugrunde eine gehauste Halbleiterschaltungsanordnung mit einer Verbindungseinrichtung in Ausgestaltung eines Folienverbunds und mit externen Kontakteinrichtungen zur reversiblen Verbindung mit externen Zuleitungen vorzustellen.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einer gehausten Halbleiterschaltungsanordnung mit mindestens einem Substrat. Dieses Substrat weist eine Mehrzahl von Leiterbahnen auf, worauf Halbleiterbauelemente schaltungsgerecht angeordnet sind. Diese Halbleiterbauelemente sind beispielhaft als integrierte Schaltungen oder als Einzelbauelemente wie Dioden oder Transistoren ausgebildet. Es kann bevorzugt sein wenn mindestens eines der Halbleiterbauelemente ein Leistungshalbleiterbauelement, wie beispielhaft ein Leistungstransistor oder eine Leistungsdiode ist. Weiterhin können auf den Leiterbahnen des Substrats passive elektronische Bauelemente wie Widerstände und / oder Kondensatoren schaltungsgerecht angeordnet sein.

Die Halbleiterschaltungsanordnung weist zur Verbindung der Halbleiterbauelemente mindestens eine Verbindungseinrichtung auf. Diese besteht aus einem Folienverbund mit mindestens zwei elektrisch leitenden Schichten, beispielhaft aus Kupfer oder Aluminium, mit jeweils einer dazwischen angeordneten isolierenden Schicht, wobei mindestens eine leitende Schicht in sich strukturiert ist und somit Leiterbahnen ausbildet.

Mindestens eine dieser leitenden Schichten weist erste interne Kontakteinrichtungen zu Anschlussflächen zugeordneter Halbleiterbauelemente auf. Erfindungsgemäß weist diese und / oder eine weitere leitende Schicht einen Teilabschnitt auf, der Teil mindestens einer zweiten reversibel ausgebildeten Kontakteinrichtung zur Verbindung mit externen Zuleitungen ist. Diese externe Kontakteinrichtung weist mindestens ein Federelement mit einem Widerlager im Gehäuse oder mindestens eine Feststellschraube auf. Die Variante mit dem Federelement bildet somit eine selbst arretierende Kontakteinrichtung aus, bei der eine externe Zuleitung eine Steckverbindung mit der Kontakteinrichtung eingeht. Die Variante mit Feststellschraube ist als Schraub Klemmverbindung nach dem Stand der Technik ausgebildet.
Die erfinderische Lösung wird an Hand der Ausführungsbeispiele der Fig. 1 bis 4 weiter erläutert.
Fig. 1 zeigt eine erste Ausgestaltung einer erfindungsgemäßen gehausten Halbleiterschaltungsanordnung im Schnitt.
Fig. 2 zeigt eine zweite Ausgestaltung einer erfindungsgemäßen gehausten Halbleiterschaltungsanordnung im Schnitt.
Fig. 3 zeigt eine dritte Ausgestaltung einer erfindungsgemäßen gehausten Halbleiterschaltungsanordnung im Schnitt.
Fig. 4 zeigt eine vierte Ausgestaltung einer erfindungsgemäßen gehausten Halbleiterschaltungsanordnung im Schnitt.

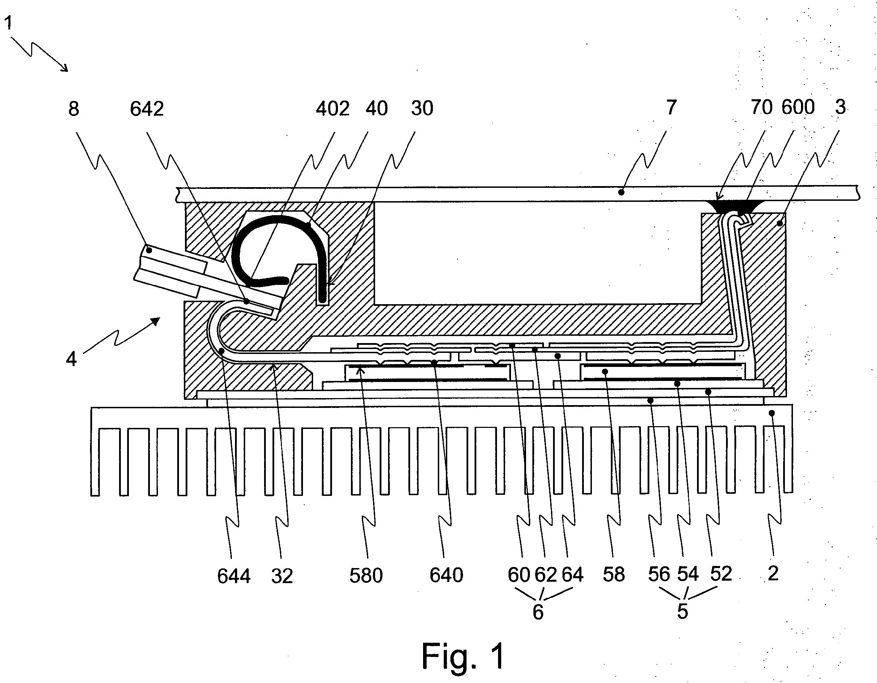

Fig. 1 zeigt eine erste Ausgestaltung einer erfindungsgemäßen gehausten Halbleiterschaltungsanordnung (1) im Schnitt in einer Anordnung mit einem Kühlkörper (2) und einer Leiterplatte (7). Die Halbleiterschaltungsanordnung (1) ist hier als Leistungshalbleitermodul ausgestaltet. Dieses besteht aus einem Gehäuse (3), welches ein Substrat (5) teilweise umschließt. An diesem elektrisch isolierend ausgebildeten Substrat (5) ist der Kühlkörper (2) angeordnet und thermisch leitend mit dem Substrat (5) verbunden.

Die dem Inneren des Leistungshalbleitermoduls (1) zugewandte Seite des Substrats (5) ist ausgebildet als eine Mehrzahl von voneinander elektrisch isolierten Leiterbahnen (54). Auf diesen Leiterbahnen ist eine Mehrzahl von Halbleiterbauelementen (58), beispielhaft Leistungsdioden und / oder Leistungstransistoren und / oder integrierte Schaltkreise angeordnet und schaltungsgerecht verbunden. Zwischen dem Grundkörper (52) des Substrats und dem Kühlkörper (2) ist eine thermisch leitende Schicht (56) angeordnet.

Weiterhin weist das Leistungshalbleitermodul (1) eine Verbindungseinrichtung (6) auf, die aus einem Folienverbund besteht. Dieser Folienverbund wird hier gebildet aus einer ersten (60) und einer zweiten (64) leitenden jeweils in sich strukturierten und somit Leiterbahnen ausbildenden Schicht und einer dazwischen angeordneten isolierenden Schicht (62). Die erste leitende Schicht (60) ist hier als Aluminiumfolie, die zweite (64) als eine Kupferfolie und die isolierende (62) als Kunststofffolie ausgebildet. Die jeweiligen Schichten (60, 62; 64) weisen eine der jeweiligen Funktion angepasste Schichtdicke zwischen 10µm und 500µm auf.

Die erste leitende Schicht (60) weist eine externe Kontakteinrichtung (600), hier ausgebildet als eine Lötverbindung, zur Leiterplatte (7) auf. Diese erste leitende Schicht (60) ist in sich strukturiert und bildet somit Leiterbahnen aus. Der Folienverbund (6) weist weiterhin schaltungsgerechte Durchkontaktierungen von Leiterbahnen dieser ersten leitenden Schicht (60) zur zweiten leitenden Schicht (64) bzw. dort ausgebildeten Leiterbahnen auf.

Diese zweite leitende Schicht (64) dieses Folienverbunds (6) weist erste, als Punktschweißverbindungen ausgebildete innere Kontakteinrichtungen (640) zu Anschlussflächen (580) von Halbleiterbauelementen (58) auf. Alternativ sind hier Klebe-, Löt- oder auch Druckkontaktverbindungen möglich. Die Halbleiterbauelemente (58) sind hier als Leistungshalbleiterbauelemente, je ein Leistungstransistor und eine Leistungsdiode ausgebildet. Grundsätzlich ist hier allerdings die Anordnung beliebiger aktiver, beispielhaft in Ausgestaltung integrierter Schaltkreise, und / oder passiver elektronischer Bauelemente, beispielhaft in Ausgestaltung von Widerständen, möglich.

Erfindungsgemäß bildet ein Teil der zweiten leitenden Schicht (64) einen Teil einer zweiten externen Kontakteinrichtung (4), hier ein Lastanschluss, zur Verbindung mit einer externen Zuleitung (8). Hierzu ist ein Abschnitt (644) der zweiten leitenden Schicht (64) im Bereich der zweiten Kontakteinrichtung (4) in einer Führung (32) im Gehäuse (3) derart angeordnet, dass sie um mehr als 180 Grad gebogen ist und eine Kontaktfläche (642) zur externen Zuleitung (8) ausbildet.

Die zweite Kontakteinrichtung (4) ist hierbei selbst arretierend ausgebildet. Hierzu weist diese zweite Kontakteinrichtung (4) ein Federelement (40) mit einem Widerlager (30) im Gehäuse (3) auf. Dieses Federelement (40) drückt mit seiner Kontaktfläche (402) derart auf die externe Zuleitung (8), dass diese Zuleitung zwischen der leitenden Schicht (64) und dem Federelement (40) geklemmt ist und somit die elektrisch leitende Verbindung zur zweiten leitenden Schicht (64) hergestellt ist.

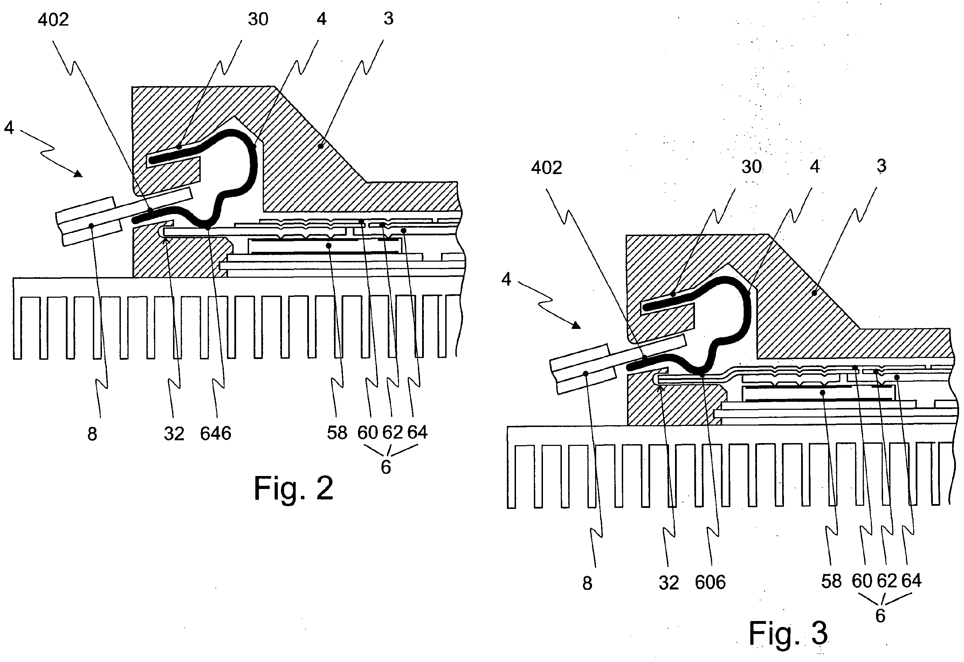

Fig. 2 zeigt eine zweite Ausgestaltung einer erfindungsgemäßen gehausten Halbleiterschaltungsanordnung (1) im Schnitt. Hierbei entspricht der grundsätzliche Aufbau des Substrats (5) und des Folienverbund (6) demjenigen gemäß Fig. 1.

Die zweite Kontakteinrichtung (4) verbindet hier wiederum als externer Lastanschluss die zweite leitende Schicht (64) des Folienverbunds (6) mit einer externen Zuleitung (8). Bei dieser Ausgestaltung weist die zweite leitende Schicht (64) keine Biegung auf, sie ist ausschließlich in einem Teilabschnitt in einer Ausnehmung (32) des Gehäuses (3) geführt.

Der elektrische Kontakt zwischen der externen Zuleitung (8) und der zweiten leitenden Schicht (64) ist mittels eines Federelements (40) ausgebildet. Hierzu weist das Federelement (40) ein Widerlager (30) im Gehäuse (3) des Leistungshalbleitermoduls (1) auf. Durch Einstecken der externen Zuleitung (8) wird diese mit einer ersten Kontaktfläche (402) des Federelements (40) elektrisch leitend verbunden, gleichzeitig wird eine zweite Kontaktfläche (646) des geeignet geformten Federelements (40) auf die zweite leitende Schicht (64) gedrückt und bildet somit den elektrischen Kontakt aus.

Die externe Zuleitung (8) kann hier beispielhaft als ein einzelnes Kabel oder als Kontakteinrichtung einer Leiterplatte ausgebildet sein.

Fig. 3 zeigt eine dritte Ausgestaltung einer erfindungsgemäßen gehausten Halbleiterschaltungsanordnung (1) im Schnitt, wobei sich diese von derjenigen gemäß Fig. 2 dahingehend unterscheidet, dass hier die erste leitende Schicht (60) mit einer externen Zuleitung (8) verbunden ist.

Da es vorteilhaft sein kann die erste leitende Schicht (60) dünner im Vergleich zur zweiten (64) auszubilden ist es hier bevorzugt die isolierende Schicht (62) auch im Bereich der zweiten Kontakteinrichtung (4) nicht von der ersten leitenden Schicht (60) zu entfernen.

Die zweite Kontakteinrichtung (4) weist ebenso wie gemäß Fig. 2 eine erste Kontaktfläche (402) zur externen Zuleitung (8) sowie eine zweite Kontaktfläche (606) zur zugeordneten, hier der ersten, leitenden Schicht (60) auf. Da diese erste leitende Schicht (60) besonders geeignet ist für Steuer- und Hilfsanschlüsse ist es hier bevorzugt eine Mehrzahl gleichartiger zweiter Kontakteinrichtungen (4) nebeneinander anzuordnen und somit eine Mehrzahl eng benachbarter externer Verbindungen vorzusehen.

Die externe Zuleitung (8) kann hier beispielhaft als ein einzelnes Kabel oder als eine Ader eines Flachbandkabels ausgebildet sein.

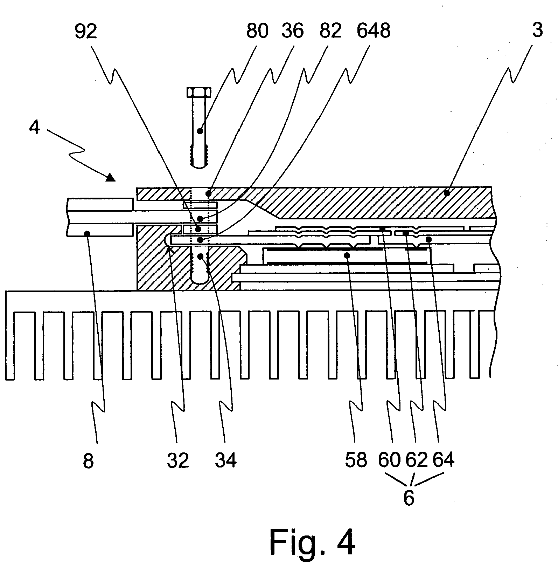

Fig. 4 zeigt eine vierte Ausgestaltung einer erfindungsgemäßen gehausten Halbleiterschaltungsanordnung (1) im Schnitt. Hierbei entspricht der grundsätzliche Aufbau des Substrats und des Folienverbunds (6) demjenigen gemäß Fig. 2.

Die zweite Kontakteinrichtung (4) verbindet hier wiederum als Lastanschluss die zweite leitende Schicht (64) des Folienverbunds (6) mit einer externen Zuleitung (8). Bei dieser Ausgestaltung weist die zweite leitende Schicht (64) ebenfalls keine Biegung auf, sie ist ausschließlich in einem Teilabschnitt in einer Ausnehmung (32) des Gehäuses (3) geführt.

Der elektrische Kontakt zwischen der externen Zuleitung (8) und der zweiten leitenden Schicht (64) ist mittels einer Schraub- Klemmverbindung mit einer Feststellschraube (80) ausgebildet. Hierzu weist der rahmenartige Teil des Gehäuses (3) eine Aufnahme (34) mit einem Gewinde auf. Die zweite leitende Schicht (64) weist ein mit dem Gewinde fluchtende Ausnehmung (648) auf. Zwischen der leitenden Schicht (64) und der externen Zuleitung (8), die hier als flächiges Metallformteil und einer passend angeordneter Ausnehmung (82) ausgebildet ist, ist mindestens ein weiteres Metallformteil (92) mit einer Ausnehmung angeordnet um Drehmomente der Schraubverbindung aufzunehmen und die daraus resultierende Belastung auf die erste leitende Schicht (64) möglichst gering zu halten. Der Deckel des Leistungshalbleitermoduls (1) weist ebenso eine fluchtende Ausnehmung (36) zur Aufnahme der Feststellschraube (80) auf.

## Patentansprüche

1. Gehauste Halbleiterschaltungsanordnung (1) mit mindestens einem Substrat (5) mit Leiterbahnen (54) und hierauf schaltungsgerecht angeordneten Halbleiterbauelementen (58) und mit einer über den Halbleiterbauelementen (58) angeordneten Verbindungseinrichtung (6),
aus einem Folienverbund aus mindestens zwei elektrisch leitenden Schichten (60, 64) mit jeweils einer dazwischen angeordneten isolierenden Schicht (62), wobei mindestens eine der elektrisch leitenden Schichten (60, 64) in sich strukturiert ist und somit Leiterbahnen ausbildet ,
wobei mindestens eine der elektrisch leitenden Schichten (60, 64) erste Kontakteinrichtungen (640) zu Anschlussflächen (580) der Halbleiterbauelemente (58) aufweist und wobei mindestens ein Teil dieser und / oder einer weiteren der elektrisch leitenden Schichten (60, 64) ein Teil mindestens einer zweiten Kontakteinrichtung (4) zur reversiblen Verbindung mit einer externen Zuleitung (8) ist,
wobei die zweite Kontakteinrichtung (4) mindestens ein Federelement (40) mit einem Widerlager (32) im Gehäuse (3) oder mindestens eine Feststellschraube (80) aufweist.

2. Gehauste Halbleiterschaltungsanordnung nach Anspruch 1,
wobei mindestens ein Halbleiterbauelement (58) ein Leistungshalbleiterbauelement, wie ein Leistungstransistor oder eine Leistungsdiode ist.

3. Gehauste Halbleiterschaltungsanordnung nach Anspruch 1,
wobei mindestens ein Halbleiterbauelement (58) ein integrierter Schaltkreis ist.

4. Gehauste Halbleiterschaltungsanordnung nach Anspruch 1,
die Schichtdicken der leitenden und isolierenden Schichten (60, 62, 64) zwischen 10µm und 500µm beträgt.

5. Gehauste Halbleiterschaltungsanordnung nach Anspruch 1, Alternative mit der zweiten Kontakteinrichtung (4) mit dem mindestens einen Federelement (40),
wobei das Federelement (40) der zweiten Kontakteinrichtung (4) eine erste Kontaktfläche (402) zur externen Zuleitung sowie eine zweite Kontaktfläche (606, 646) zur zugeordneten leitenden Schicht (60, 64) aufweist.

6. Gehauste Halbleiterschaltungsanordnung nach Anspruch 1, Alternative mit der zweiten Kontakteinrichtung (4) mit dem mindestens einen Federelement (40),
wobei das Federelement (40) der zweiten Kontakteinrichtung (4) eine erste Kontaktfläche (402) und die zugeordnete leitende Schicht (60, 64) eine Kontaktfläche (642) zur externen Zuleitung (8) aufweisen.

7. Gehauste Halbleiterschaltungsanordnung nach Anspruch 1,
wobei ein Abschnitt der leitenden Schicht (60, 64) im Bereich der zweiten Kontakteinrichtung (4) eine Führung (32) im Gehäuse (3) aufweist.

8. Gehauste Halbleiterschaltungsanordnung nach Anspruch 1,
wobei die erste Kontakteinrichtung (580) als Lötverbindung oder als Klebeverbindung oder als Druckkontaktierung oder als Punktschweißverbindung ausgebildet ist.

## Claims

1. Enclosed semiconductor circuit arrangement (1) comprising at least one substrate (5) with conductor tracks (54) and semiconductor components (58) arranged on said conductor tracks in a manner suitable for the circuit, and comprising a connecting device (6) which is arranged above the semiconductor components (58), composed of a foil composite comprising at least two electrically conductive layers (60, 64) with in each case one insulating layer (62) arranged between them, wherein at least one of the electrically conductive layers (60, 64) is inherently structured and therefore forms conductor tracks, wherein at least one of the electrically conductive layers (60, 64) has first contact devices (640) to connection areas (580) of the semiconductor components (58), and wherein at least some of these layers and/or a further one of the electrically conductive layers (60, 64) is part of at least one second contact device (4) for reversible connection to an external supply line (8), wherein the second contact device (4) has at least one spring element (40) with an abutment (32) in the housing (3) or has at least one fixing screw (80).

2. Enclosed semiconductor circuit arrangement according to Claim 1, wherein at least one semiconductor component (58) is a power semiconductor component, such as a power transistor or a power diode.

3. Enclosed semiconductor circuit arrangement according to Claim 1, wherein at least one semiconductor component (58) is an integrated circuit.

4. Enclosed semiconductor circuit arrangement according to Claim 1, the layer thicknesses of the conductive and insulating layers (60, 62, 64) are between 10 µm and 500 µm.

5. Enclosed semiconductor circuit arrangement according to Claim 1, alternatively comprising the second contact device (4) with the at least one spring element (40), wherein the spring element (40) of the second contact device (4) has a first contact area (402) to the external supply line and also a second contact area (606, 646) to the associated conductive layer (60, 64).

6. Enclosed semiconductor circuit arrangement according to Claim 1, alternatively comprising the second contact device (4) with the at least one spring element (40), wherein the spring element (40) of the second contact device (4) has a first contact area (402) and the associated conductive layer (60, 64) has a contact area (642) to the external supply line (8).

7. Enclosed semiconductor circuit arrangement according to Claim 1, wherein a section of the conductive layer (60, 64) in the region of the second contact device (4) has a guide (32) in the housing (3).

8. Enclosed semiconductor circuit arrangement according to Claim 1, wherein the first contact device (580) is in the form of a solder connection or in the form of an adhesive connection or in the form of a pressure contact-connection means or in the form of a spot-weld connection.

## Revendications

1. Dispositif de circuit à semiconducteur intégré dans un boîtier (1) avec au moins un substrat (5) comprenant des pistes conductrices (54) et des composants à semiconducteur (58), lesquels sont disposés à cet effet conformément au circuit, et avec un mécanisme de raccordement (6), lequel est disposé au-dessus des composants à semiconducteur (58) et lequel est constitué d'un système composite de feuilles réalisé à partir d'au moins deux couches électriquement conductrices (60, 64) qui comprennent respectivement une couche isolante (62), laquelle est disposée entre les au moins deux couches (60, 64) électriquement conductrices ;
dans lequel au moins l'une des couches électriquement conductrices (60, 64) est structurée en soi et forme par conséquent des pistes conductrices ;
dans lequel au moins l'une des couches électriquement conductrices (60, 64) présente des premiers mécanismes de mise en contact (640) avec des surfaces de connexion (580) des composants à semiconducteur (58) ; et
dans lequel au moins une partie de ces couches électriquement conductrices (60, 64) et/ou une autre couche électriquement conductrice (60, 64) forment une partie d'au moins un deuxième mécanisme de mise en contact (4) en vue de la connexion réversible avec une ligne d'alimentation (8) ;
dans lequel le deuxième mécanisme de mise en contact (4) présente au moins un élément formant ressort (40) avec un palier de butée (32), lequel se trouve dans le boîtier (3), ou présente au moins une vis de blocage (80).

2. Dispositif de circuit à semiconducteur intégré dans un boîtier selon la revendication 1,
dans lequel au moins un composant à semiconducteur (58) est un composant de puissance à semiconducteur, tel qu'un transistor de puissance ou une diode de puissance.

3. Dispositif de circuit à semiconducteur intégré dans un boîtier selon la revendication 1,
dans lequel au moins un composant à semiconducteur (58) est un circuit intégré.

4. Dispositif de circuit à semiconducteur intégré dans un boîtier selon la revendication 1,
l'épaisseur de couche des couches conductrices et de la couche isolante (60, 62, 64) est comprise entre 10 µm et 500 µm.

5. Dispositif de circuit à semiconducteur intégré dans un boîtier selon la revendication 1, en alternative avec le deuxième mécanisme de mise en contact (4) avec l'au moins un élément formant ressort (40) ; dans lequel l'élément formant ressort (40) du deuxième mécanisme de mise en contact (4) présente une première surface de contact (402) avec la ligne d'alimentation externe, ainsi qu'une deuxième surface de contact (606, 646) avec la couche conductrice (60, 64) associée.

6. Dispositif de circuit à semiconducteur intégré dans un boîtier selon la revendication 1, en alternative avec le deuxième mécanisme de mise en contact (4) avec l'au moins un élément formant ressort (40) ; dans lequel l'élément formant ressort (40) du deuxième mécanisme de mise en contact (4) présente une première surface de contact (402) et la couche conductrice (60, 64) associée présente une surface de contact (642) avec la ligne d'alimentation (8) externe.

7. Dispositif de circuit à semiconducteur intégré dans un boîtier selon la revendication 1,
dans lequel une section de la couche conductrice (60, 64) présente un guidage (32) dans le boîtier (3), dans la zone du deuxième mécanisme de mise en contact (4).

8. Dispositif de circuit à semiconducteur intégré dans un boîtier selon la revendication 1,
dans lequel le premier mécanisme de mise en contact (580) est conçu sous la forme d'une connexion par brasage ou sous la forme d'une liaison par collage ou sous la forme d'une mise en contact par pression ou sous la forme d'une liaison par soudure par points.
